# EUROPEAN PATENT APPLICATION

(11) **EP 4 606 519 A1**
(43) Date of publication of application: **27.08.2025**
(21) Application number: 23879604.9
(22) Date of filing: 03.10.2023
(51) Int. Cl.: B24B 37/24, B24B 37/00, C09G 1/02, C09K 3/14, H01L 21/301, H01L 21/304

(54) **POLISHING METHOD AND METHOD FOR PRODUCING SEMICONDUCTOR COMPONENT**

(30) Priority: 20.10.2022 JP 2022168156; 09.03.2023 JP 2023036300
(71) Applicant: AGC INC., Chiyoda-ku, Tokyo 1008405 (JP)
(72) Inventor: OTSUKA, Yuya, Tokyo 100-8405 (JP); AKAJI, Masatoshi, Tokyo 100-8405 (JP); SHIBUYA, Tomohiro, Tokyo 100-8405 (JP)
(74) Representative: Müller-Boré & Partner Patentanwälte PartG mbB
(86) International application number: PCT/JP2023/036045
(87) International publication number: WO 2024/084957

(57) **Abstract**

To provide a polishing method in which the generation of polishing scratches can be sufficiently suppressed while a sufficiently high polishing rate or selection ratio of an insulating film is maintained and a method for producing a semiconductor component using the polishing method. A polishing method including bringing a surface to be polished into contact with a polishing pad while supplying a polishing agent to perform polishing through relative motion thereof, in which the polishing agent contains an abrasive particle and water, the polishing pad has a polishing layer containing a polyurethane resin, the polyurethane resin includes a constitution unit derived from methylene diphenyl diisocyanate (MDI), a content of the methylene diphenyl diisocyanate is 30 mass% or more based on a total mass of the polishing layer, the polishing layer has a shore A hardness of 90 degrees or less, the polishing layer has a water absorption coefficient of 5% or more, and the surface to be polished includes an insulating film.

## Description

### Technical Field

The present invention relates to a polishing method and a method for producing a semiconductor component.

### Background Art

Along with the higher integration and higher performance of semiconductor integrated circuits, development of microfabrication techniques for the miniaturization and higher density of semiconductor elements is in progress. Conventionally, in the production of semiconductor integrated circuit devices (hereinafter, also referred to as semiconductor devices), interlayer insulation films, buried wirings, or the like have been planarized using a chemical mechanical polishing method (hereinafter, referred to as CMP) to prevent a problem of a sufficient resolution that cannot be obtained due to unevenness (level difference) on layer surfaces exceeding the depth of focus in lithography.

Recently, in the production of a semiconductor device, an isolation method with a shallow trench having a small element isolation width (shallow trench isolation: hereinafter, referred to as STI) has been introduced to miniaturize semiconductor elements in a further advanced manner.

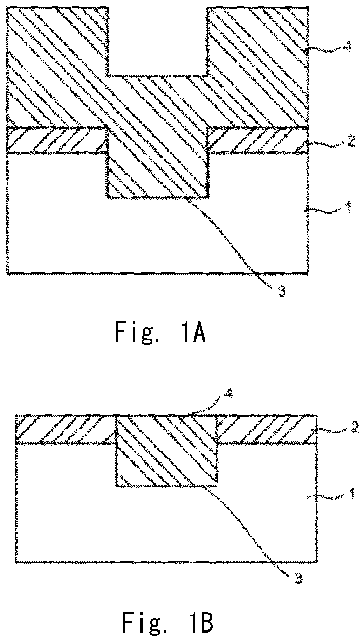

STI is a method in which a trench (groove) is formed in a silicon substrate, and an insulating film is buried in the trench, thereby forming an electrically insulated element region. One example of STI will be described with reference to Fig. 1A and Fig. 1B. In this example, first, as shown in Fig. 1A, an element region of a silicon substrate 1 is masked with a silicon nitride film 2 or the like, a trench 3 is then formed in the silicon substrate 1, and an insulating film, such as a silicon oxide film 4, is deposited to bury the trench 3. Next, the silicon oxide film 4 on the silicon nitride film 2, which is a protrusion part, is polished and removed by CMP while the silicon oxide film 4 in the trench 3, which is a recess part, is left, whereby an element isolation structure in which the silicon oxide film 4 has been buried in the trench 3 as shown in Fig. 1B is obtained. In addition, while not shown, there is a case where the silicon nitride film 2 is also removed.

In Patent Literature 1, it has been disclosed that in a polishing method including polishing a film to be polished while supplying a polishing agent between the film to be polished and a polishing pad, abrasive particles, such as tetravalent cerium oxide particles, and a polishing pad having a Shore D hardness of 41 to 59 are used. In an example of Patent Literature 1, it has been shown that the polishing rate of SiO₂ becomes low in a combination of a polishing pad having a Shore D hardness of less than 41 and abrasive particles.

### Citation List

### Patent Literature

Patent Literature 1: Japanese Unexamined Patent Application Publication No. 2010-153782

### Summary of Invention

### Technical Problem

In the CMP, it has been required to sufficiently suppress the generation of polishing scratches while maintaining a sufficiently high polishing rate or selection ratio (for example, the ratio of the polishing rate of silicon oxide to the polishing rate of silicon nitride or the ratio of the polishing rate of silicon oxide to the polishing rate of polysilicon) of an insulating film from the viewpoint of improvement in the productivity of a semiconductor element or the like.

However, an increase in the polishing rate or selection ratio of an insulating film and suppression of the generation of polishing scratches generally have a trade-off relationship, and it has been difficult to satisfy both at the same time.

The present disclosure has been made in consideration of the above-described circumstances and provides a polishing method in which the generation of polishing scratches can be sufficiently suppressed while a sufficiently high polishing rate or selection ratio of an insulating film is maintained and a method for producing a semiconductor component using the polishing method.

### Solution to Problem

The present disclosure provides a polishing method and a method for producing a semiconductor component which have the following configurations [1] to [14].
[1] A polishing method including bringing a surface to be polished of a semiconductor substrate into contact with a polishing pad while supplying a polishing agent to perform polishing through relative motion thereof, in which
   the polishing agent contains an abrasive particle and water,
   the polishing pad has a polishing layer containing a polyurethane resin,
   the polishing layer has a shore A hardness of 90 degrees or less,
   the polishing layer has a water absorption coefficient of 5% or more,
   the polyurethane resin includes a constitution unit derived from methylene diphenyl diisocyanate (MDI),
   a content of the methylene diphenyl diisocyanate is 30 mass% or more based on a total mass of the polishing layer, and
   the surface to be polished includes an insulating film.
[2] The polishing method according to [1], in which the abrasive particle includes at least one selected from the group consisting of a silica particle, an alumina particle, a zirconia particle, a ceria particle, a titania particle, a germania particle, a cerium hydroxide particle, and a composite particle thereof.
[3] The polishing method according to [1] or [2], in which the abrasive particle includes a ceria particle.
[4] The polishing method according to any one of [1] to [3], in which a content of the abrasive particle is 0.01 mass% to 10.0 mass% based on a total mass of the polishing agent.
[5] The polishing method according to any one of [1] to [4], in which the polishing agent further contains a dispersant.
[6] The polishing method according to [5], in which the dispersant includes at least one selected from the group consisting of an anionic surfactant, a cationic surfactant, a nonionic surfactant, and an amphoteric surfactant.
[7] The polishing method according to [5] or [6], in which a content of the dispersant is 0.0001 mass% to 0.3 mass% based on a total mass of the polishing agent.
[8] The polishing method according to any one of [1] to [7], in which the polishing layer is a suede type.
[9] The polishing method according to any one of [1] to [8], in which the polishing layer is produced by a wet film forming method.
[10] The polishing method according to any one of [1] to [9], in which the polishing layer is a porous layer having a plurality of pores in a polyurethane resin part, and
   the polyurethane resin part has a three-dimensional network-shaped structure including a network-shaped polyurethane resin and fine pores.
[11] The polishing method according to [10], in which D₁/D₂ is 5.0 to 200, where D₁ represents an average pore diameter of the plurality of pores in the polyurethane resin part, and D₂ represents an average pore diameter of the fine pores.
[12] The polishing method according to any one of [1] to [11], in which the polyurethane resin includes a constitution unit derived from a polyether polyol or a polyester polyol.
[13] The polishing method according to any one of [1] to [12], in which the insulating film contains at least one selected from the group consisting of silicon oxide, silicon nitride, and polysilicon.
[14] A method for producing a semiconductor component, including singulating a semiconductor substrate having a surface to be polished that has been polished by the polishing method according to any one of [1] to [13] to provide a semiconductor component.

### Advantageous Effects of Invention

According to the present disclosure, it is possible to provide a polishing method in which the generation of polishing scratches can be sufficiently suppressed while a sufficiently high polishing rate or selection ratio of an insulating film is maintained and a method for producing a semiconductor component using the polishing method.

### Brief Description of Drawings

Fig. 1A is a view showing one example of a polishing method and is a cross-sectional view showing a state of an object to be polished before polishing;
Fig. 1B is a view showing one example of the polishing method and is a cross-sectional view showing a state of the object to be polished after polishing;
Fig. 2 is a schematic view showing one example of a polishing device;
Fig. 3 is a schematic view showing one example of a cross section of a polishing layer; and
Fig. 4 is a schematic view showing one example of a surface of a polyurethane resin.

### Description of Embodiments

Hereinafter, an embodiment of the present disclosure will be described. In order to clarify the description, the following description and drawings have been simplified as appropriate. In addition, in order for description, each member in the drawings may significantly differ in scale.

"Surface to be polished" in the present disclosure refers to a surface to be polished of an object to be polished and means, for example, a front surface. In the present specification, a front surface in an intermediate stage that appears in a polishing step is also included in the "surface to be polished."

"Polishing layer" in the present disclosure refers to a layer that configures a surface of a polishing pad that comes into contact with the object to be polished.

"(Meth)acrylic acid" in the present disclosure is a collective term of acrylic acid and methacrylic acid, which is also applicable to "(meth)acrylonitrile" or the like.

In addition, "to" indicating numerical ranges includes numerical values before and after "to" as the lower limit value and the upper limit value, respectively, unless particularly otherwise described.

### · Polishing Method

A polishing method of the present disclosure is a polishing method including bringing a surface to be polished of a semiconductor substrate into contact with a polishing pad while supplying a polishing agent to perform polishing through relative motion thereof, in which
the polishing agent contains an abrasive particle and water,
the polishing pad has a polishing layer containing a polyurethane resin,
the polishing layer has a shore A hardness of 90 degrees or less,
the polyurethane resin includes a constitution unit derived from methylene diphenyl diisocyanate (MDI),
a content of the methylene diphenyl diisocyanate is 30 mass% or more based on a total mass of the polishing layer, and
the surface to be polished includes an insulating film.

In the present polishing method, the above-described specific polyurethane resin is used as the polishing pad and is used in combination with the polishing agent containing an abrasive particle, whereby the polishing rate of particularly the surface to be polished including the insulating film improves. Hereinafter, each configuration will be described.

### [Polishing Agent]

In the present polishing method, the polishing agent contains at least an abrasive particle and water and may also further contain other components to an extent that the effect of the present invention is exhibited. Hereinafter, each component that can be contained in the present polishing agent will be described.

### <Abrasive particle>

In the present polishing method, the abrasive particle can be appropriately selected from abrasive particles that are used for CMP and used. Examples of the abrasive particles include at least one selected from the group consisting of a silica particle, an alumina particle, a zirconia particle, a cerium compound particle (for example, a ceria particle or a cerium hydroxide particle), a titania particle, a germania particle, and a core-shell particle containing the above-listed particle as the core particle. Examples of the silica particle include colloidal silica, fumed silica, and the like. As the alumina particle, colloidal alumina can also be used.

The core-shell particle is composed of a core particle (for example, a silica particle, an alumina particle, a zirconia particle, a cerium compound particle, a titania particle, or a germania particle) and a thin film that covers the surface of the core particle.

Examples of the material of the thin film include at least one selected from oxides such as silica, alumina, zirconia, ceria, titania, germania, iron oxide, manganese oxide, zinc oxide, yttrium oxide, calcium oxide, magnesium oxide, lanthanum oxide, strontium oxide. In addition, the thin film may be formed of a plurality of nanoparticles composed of these oxides.

The particle diameter of the core particle is preferably 0.01 µm to 0.5 µm and more preferably 0.03 µm to 0.3 µm.

The particle diameter of the nanoparticle needs to be smaller than the particle diameter of the core particle and is preferably 1 nm to 100 nm and more preferably 5 nm to 80 nm.

Among what has been described above, a silica particle, an alumina particle, or a cerium compound particle is preferable, and a cerium compound particle is more preferable as the abrasive particle since the polishing rate of the insulating film is excellent, and in a case where the surface to be polished includes an insulating film (for example, a silicon oxide film), a ceria particle is still more preferable since a high polishing rate can be obtained. In the case of a core-shell particle, the thin film preferably contains silica, alumina, or a cerium compound, and the thin film more preferably contains ceria. One type of abrasive particle can be used singly or two or more types thereof can be used in combination.

The content of ceria based on the total mass of the abrasive particle is preferably 70 mass% or more, more preferably 80 mass% or more, still more preferably 90 mass% or more, particularly preferably 95 mass% or more, and most preferably 100 mass%. When the content of ceria based on the total mass of the abrasive particle is 70 mass% or more, it is easy to obtain a high value as the polishing rate of the insulating film (particularly, a silicon oxide film).

The ceria particle can be appropriately selected and used from well-known ceria particles, and examples thereof include ceria particles produced by methods described in Japanese Unexamined Patent Application Publication No. H11-12561, Japanese Unexamined Patent Application Publication No. 2001-35818, and Published Japanese Translation of PCT International Publication for Patent Application, No. 2010-505735. Specific examples thereof include a ceria particle obtained by adding an alkali to an ammonium cerium (IV) nitrate aqueous solution to produce a cerium hydroxide gel and filtering, cleaning, and firing the gel; a ceria particle obtained by crushing, then, firing, furthermore, crushing, and classifying high-purity cerium carbonate; a ceria particle obtained by chemically oxidizing a cerium (III) salt in a liquid; and the like.

The ceria particle may contain an impurity other than ceria, but the content of ceria in one ceria particle is preferably 80 mass% or more, more preferably 90 mass% or more, still more preferably 95% or more, and most preferably 100 mass% (no impurities are contained). When the content of ceria in the ceria particle is 80 mass% or more, it is easy to improve the polishing rate of the insulating film.

The average particle diameter of the abrasive particle is preferably 0.01 µm to 0.5 µm and more preferably 0.03 µm to 0.3 µm. When the average particle diameter is 0.5 µm or less, the mechanical action that is imparted to the surface to be polished becomes small, and the generation of a polishing scratch, such as a scratch, on the surface to be polished is thus suppressed. In addition, when the average particle diameter is 0.01 µm or more, agglomeration of the abrasive particles is suppressed, the preservation stability of the polishing agent is excellent, and the polishing rate is also excellent.

The abrasive particle is present as an agglomerated particle (secondary particle) in which primary particles have agglomerated together in a liquid, and the average particle diameter is thus the average secondary particle diameter. The average secondary particle diameter is measured using a dispersion liquid in which the secondary particles have been dispersed in a dispersion medium, such as pure water, and a particle size analyzer, such as a laser diffraction/scattering type particle size analyzer.

The lower limit value of the content of the abrasive particle is preferably 0.01 mass%, more preferably 0.05 mass%, still more preferably 0.1 mass%, and particularly preferably 0.15 mass% based on the total mass of the polishing agent. When the content of the abrasive particle is the above-described lower limit value or more, an excellent polishing rate can be obtained with respect to the surface to be polished. On the other hand, the upper limit value of the content of the abrasive particle is preferably 10.0 mass%, more preferably 8.0 mass%, still more preferably 5.0 mass%, particularly preferably 2.0 mass%, more particularly preferably 1.0 mass%, extremely preferably 0.8 mass%, and most preferably 0.5 mass% based on the total mass of the polishing agent. When the content rate of the abrasive particle is the above-described upper limit value or less, it is possible to suppress agglomeration of the abrasive particles, an increase in the viscosity of the present polishing agent is suppressed, and the handleability is excellent.

### <Water>

The present polishing agent contains water as a medium for dispersing the abrasive particle (A). The kind of the water is not particularly limited, but pure water, ultrapure water, ion exchange water, or the like is preferably used in consideration of an influence on other components, the prevention of the incorporation of an impurity, and an influence on the pH or the like.

### <Additives>

The present polishing agent may further contain a variety of additives. Examples of the additives include a pH adjuster, a dispersant, a water-soluble polymer, an anti-agglomeration agent, a lubricant, a viscosity imparting agent, a viscosity modifier, a preservative, and the like, and two or more types of additives may be contained.

### (pH Adjuster)

A pH adjuster may be contained to adjust the pH to a predetermined value. As the pH adjuster, a pH adjuster can be appropriately selected and used from acidic compounds, basic compounds, amphoteric compounds, such as amino acid, and salts thereof.

Examples of the acidic compounds include inorganic acids, organic acids or salts thereof. Examples of the inorganic acids include nitric acid, sulfuric acid, hydrochloric acid, phosphoric acid, and the like, and ammonium salts, sodium salts, potassium salts, and the like thereof may also be used.

Examples of the organic acids include compounds having a carboxy group, a sulfo group, or a phosphor group as an acidic group, ammonium salts, sodium salts, potassium salts, and the like thereof.

Examples of the organic acids having a carboxy group include alkyl monocarboxylic acids such as formic acid, acetic acid, and propionic acid;
carboxylic acids having a heterocycle, such as 2-pyridinecarboxylic acid, 3-pyridinecarboxylic acid, 4-pyridinecarboxylic acid, 2,3-pyridinedicarboxylic acid, 2,4-pyridinedicarboxylic acid, 2,5-pyridinedicarboxylic acid, 2,6-pyridinedicarboxylic acid, 3,4-pyridinedicarboxylic acid, 3,5-pyridinedicarboxylic acid, pyrazine carboxylic acid, 2,3-pyrazinedicarboxylic acid, 2-quinoline carboxylic acid, pyroglutamic acid, picolinic acid, DL-pipecolic acid, 2-furan carboxylic acid, 3-furan carboxylic acid, tetrahydrofuran-2-carboxylic acid, and tetrahydrofuran-2,3,4,5-tetracarboxylic acid;
carboxylic acids having an alicyclic ring, such as cyclopentane carboxylic acid, cyclohexane carboxylic acid, cycloheptane carboxylic acid, and cyclohexyl carboxylic acid;
carboxylic acids having an amino group, such as alanine, glycine, glycylglycine, aminobutyric acid, N-acetylglycine, N,N-di(2-hydroxyethyl)glycine, N-(tert-butoxycarbonyl)glycine, proline, trans-4-hydroxyL-proline, phenylalanine, sarcosine, hydantoic acid, creatine, N-[tris(hydroxymethyl)methyl]glycine, glutamic acid, and aspartic acid;
carboxylic acids having a hydroxyl group, such as lactic acid, malic acid, citric acid, tartaric acid, glycolic acid, gluconic acid, salicylic acid, 2-hydroxyisobutyric acid, glyceric acid, 2,2-bis(hydroxymethyl)propionic acid, and 2,2-bis(hydroxymethyl)butyric acid;
carboxylic acids having a ketone group (keto acids), such as pyruvic acid, acetoacetic acid, and levulinic acid;
dicarboxylic acids such as oxalic acid, malonic acid, succinic acid, fumaric acid, maleic acid, glutaric acid, adipic acid, and phthalic acid; and the like.

In a case where an acid is used as the pH adjuster in the present polishing agent, the inorganic acids are preferable, and among them, nitric acid, sulfuric acid, hydrochloric acid, phosphoric acid, and ammonium salts, sodium salts, and potassium salts thereof are preferable.

Examples of the basic compounds include ammonia, sodium hydroxide, potassium hydroxide, ammonium hydroxide, potassium carbonate, sodium carbonate, ammonium carbonate; quaternary ammonium hydroxides such as tetramethylammonium hydroxide and tetraethylammonium hydroxide; amino alcohols such as monoethanolamine, diethanolamine, and triethanolamine.

Examples of the amphoteric compounds include glycine, alanine, phenylalanine, and the like.

One type of the pH adjuster can be used singly or two or more types thereof can be used in combination. The pH of the present polishing agent is preferably 3.0 to 12.0 and more preferably 3.5 to 11.5. When the pH is adjusted to be within the above-described range, it is possible to suppress the agglomeration of the abrasive particle, and the polishing rate or selection ratio of the insulating film is excellent.

The content rate of the pH adjuster needs to be adjusted as appropriate so that the pH becomes as described above. As one example, the content rate can be set to 0.005 mass% to 2.0 mass% and is preferably 0.01 mass% to 1.5 mass% and more preferably 0.01 mass% to 0.3 mass% based on all of the present polishing agent.

### (Dispersant)

The present polishing agent may also contain a dispersant in order to improve the dispersibility of the abrasive particle. Examples of the dispersant include anionic surfactants, cationic surfactants, nonionic surfactants, amphoteric surfactants, and the like, and one or more types thereof can be used.

As the anionic surfactants, organic acids having two or more carboxylic acids or carboxylic acid bases are preferable, and at least one selected from polymers of unsaturated carboxylic acids, copolymers of an unsaturated carboxylic acid and a monomer containing no carboxylic acid groups, partially esterified products of the polymers or copolymers, and salts thereof is more preferable.

Examples of the unsaturated carboxylic acid include unsaturated monocarboxylic acids, unsaturated dicarboxylic acids, and the like. Specific examples of the unsaturated monocarboxylic acids include acrylic acid, methacrylic acid, crotonic acid, and the like. Among these, acrylic acid is preferable.

Specific examples of the unsaturated dicarboxylic acids include maleic acid, fumaric acid, itaconic acid, citraconic acid, mesaconic acid, 2-allylmalonic acid, isopropylidenesuccinic acid, and the like, and the unsaturated dicarboxylic acids may be acid anhydride forms. Among these, at least one selected from maleic acid, maleic anhydride, fumaric acid, and itaconic acid is preferable, and maleic acid, maleic anhydride, and fumaric acid are particularly preferable from the viewpoint of polymerizability.

The polymers of unsaturated carboxylic acids may be homopolymers obtained by polymerizing one type of unsaturated carboxylic acid or may be copolymers obtained by combining two or more types of unsaturated carboxylic acids. Specific examples thereof include polyacrylic acid, polymaleic acid, polyfumaric acid, polymethacrylic acid, polyitaconic acid, polycrotonic acid, acrylic acid/maleic acid copolymers, acrylic acid/methacrylic acid copolymers, acrylic acid/fumaric acid copolymers, maleic acid/fumaric acid copolymers, and the like.

The organic acids may be copolymers of an unsaturated carboxylic acid and a monomer containing no carboxylic acid groups. Examples of the monomer containing no carboxylic acid groups include sulfonic acid-based monomers, vinyl ester-based monomers, aromatic vinyl-based monomers, α-olefins, vinyl ether-based monomers, allyl compounds, N-alkyl-substituted (meth)acrylamides, and nitrile-based monomers. Here, the (meth)acrylamide is a collective term of acrylamide and methacrylamide, and the same interpretation is also applied to the case of other compounds.

Examples of the sulfonic acid-based monomers include 2-acrylamido-2-methylpropanesulfonic acid, styrenesulfonic acid, allylsulfonic acid, methacrylsulfonic acid, and the like; examples of the vinyl ester-based monomers include vinyl acetate, vinyl propionate, and the like; examples of the aromatic vinyl-based monomers include styrene, methylstyrene, vinylnaphthalene, and the like; examples of the α-olefins include isobutylene, diisobutylene, and the like; examples of the vinyl ether-based monomers include vinyl methyl ether, vinyl ethyl ether, vinyl isobutyl ether, and the like; examples of the allyl compounds include allyl alcohol, allyl ethyl ether, allyl butyl ether, alkylene oxide (hereinafter, referred to as AO) adducts of allyl glycidyl ether or allyl alcohol (examples of the AO adducts include ethylene oxide (hereinafter, referred to as EO) adducts and propylene oxide (hereinafter, referred to as PO) adducts), and the like; examples of the N-alkyl-substituted (meth)acrylamides include N-methyl(meth)acrylamide, N-ethyl(meth)acrylamide, and the like, and examples of the nitrile-based monomers include (meth)acrylonitrile and the like.

In addition, as the monomer containing no carboxylic acid groups, unsaturated carboxylic acid esters such as (meth)acrylic acid ester-based monomers may also be used. As described above, partially esterified products of the polymer of unsaturated carboxylic acids can be obtained by copolymerizing an unsaturated carboxylic acid and an unsaturated carboxylic acid ester. The partially esterified products of the polymer of unsaturated carboxylic acids may also be obtained by partially esterifying the polymer of unsaturated carboxylic acids by a well-known method. Similarly, partially esterified products of the copolymer of an unsaturated carboxylic acid and a monomer containing no carboxylic acid groups can be obtained by copolymerizing an unsaturated carboxylic acid, an unsaturated carboxylic acid ester, and other monomers.

The unsaturated carboxylic acid ester is, for example, a compound in which a carboxylic acid group (-C(=O)-OH) of an unsaturated carboxylic acid has turned into -C(=O)-O-R¹ (R¹ is a monovalent substituent). R¹ is preferably a substituted or unsubstituted saturated hydrocarbon group having 1 to 50 carbon atoms and optionally having an oxygen atom between carbon atoms. R¹ is a substituted or unsubstituted saturated hydrocarbon group more preferably having 2 to 30 carbon atoms, still more preferably having 5 to 20 carbon atoms, and optionally having an oxygen atom between carbon atoms. The saturated hydrocarbon group may be a straight chain, a branched chain, or cyclic and may be a straight chain or branched chain having a cyclic structure. Furthermore, examples of the substituent in the substituted saturated hydrocarbon group include a hydroxyl group, an epoxy group, an amino group, and the like.

Specific examples of R¹ include a methyl group, an ethyl group, a propyl group, a n-butyl group, a 2-ethylhexyl group, a lauryl group, a 2-hydroxyethyl group, a polyethylene glycol group, a methoxypolyethylene glycol group, a glycidyl group, a dimethylaminoethyl group, a diethylaminoethyl group, and the like. As the unsaturated carboxylic acid ester, (meth)acrylic acid esters are preferable.

The organic acids that have thus far described are organic acids having a plurality of carboxylic acid groups. The organic acids having carboxylic acid bases are organic acids in which at least a part of the carboxylic acid groups in the above-described organic acid has been chlorinated. Examples of a counter ion of a salt of the carboxylic acid base include alkaline metal salts such as sodium and potassium, alkaline earth metal salts such as magnesium and calcium, ammonium salts, amine salts, and organic amine salts. Alkaline metal salts, such as sodium and potassium, and ammonium salts are preferable from the viewpoint of solubility in water that is used in the polishing agent. Ammonium salts are more preferable.

The polymers or copolymers that become the organic acids can be obtained by polymerizing the above-described monomers singly or in appropriate combination by a well-known method. The weight average molecular weight of the organic acid is preferably 500 to 1,000,000, more preferably 1,000 to 20,000, and still more preferably 2,000 to 10,000. When the weight average molecular weight of the organic acid is 500 or more, it is possible to stably secure a state in which the organic acid has been adsorbed to the surfaces of cerium oxide particles or the surface to be polished including a silicon nitride film. When the weight average molecular weight of the organic acid is 1,000,000 or less, handleability or the like is good. The weight average molecular weight in the present specification is a weight average molecular weight that is measured by gel permeation chromatography (GPC) unless particularly otherwise described.

The rate of a unsaturated carboxylic acid unit in the organic acid is preferably 40 to 100 mol%, more preferably 50 to 100 mol%, and still more preferably 60 to 100 mol%, and it is particularly preferable that the organic acid is substantially only the unsaturated carboxylic acid unit. The organic acid being substantially only the unsaturated carboxylic acid unit refers to the fact that the rate of the unsaturated carboxylic acid unit in all units is 95 mol% or more and preferably 98 mol% or more.

The organic acid that is used in the present invention is preferably an organic acid substantially consisting of an unsaturated carboxylic acid unit, more preferably an organic acid containing acrylic acid as an essential constitution unit, and particularly preferably a polyacrylic acid substantially consisting of an acrylic acid unit.

Examples of the cationic surfactants include diallyldimethylammonium chloride polymers, diallyldimethylammonium chloride/sulfur dioxide copolymers, diallyldimethylammonium chloride/acrylamide copolymers, diallyldimethylammonium chloride maleic acid copolymers, maleic acid/diallyldimethylammonium ethyl sulfate/sulfur dioxide copolymers, and the like.

The weight average molecular weight of the surfactant is preferably 10,000 to 100,000 from the viewpoint of polishing the surface to be polished at a higher rate.

The lower limit value of the content of the dispersant in the case of being used is preferably 0.0001 mass%, more preferably 0.001 mass%, and still more preferably 0.01 mass% based on the total mass of the polishing agent. In addition, the upper limit value of the content thereof is preferably 2.0 mass%, more preferably 1.5 mass%, still more preferably 1.0 mass%, particularly preferably 0.5 mass%, extremely preferably 0.2 mass%, and most preferably 0.1 mass% based on the total mass of the polishing agent. When the content of the dispersant is within the above-described range, it becomes possible to polish the surface to be polished at a higher rate.

### (Lubricant)

In addition, the present polishing agent may also contain a lubricant. The lubricant is an additive that is used if necessary to improve the lubricity of the polishing agent and improve the in-plane uniformity of the polishing rate, and examples thereof include water-soluble polymers such as polyethylene glycol and polyglycerin.

In a case where each of the above-described additives is used in the present polishing agent, the total content of the additives is preferably 0.01 mass% to 10.0 mass% and more preferably 0.01 mass% to 5.0 mass% based on the total mass of the polishing agent from the viewpoint of polishing the surface to be polished at a higher rate.

### <Method for Preparing Polishing Agent>

A method for preparing the present polishing agent may be selected as appropriate from methods in which the abrasive particle and a variety of additives that are used if necessary are uniformly dispersed or dissolved in water, which is a medium.

For example, the present polishing agent may be prepared by preparing a dispersion liquid of the abrasive particle and water and/or an aqueous solution containing a variety of additives (also referred to as an additive liquid for the polishing agent), respectively, and mixing these. According to this method, the preservation stability or transportation convenience of the dispersion liquid and the additive liquid for the polishing agent is excellent. The present polishing agent may be prepared at the time of use by performing the above-described mixing in a polishing device.

In the case of preparing a polishing agent by preparing two liquids of the dispersion liquid of the abrasive particle and the additive liquid for the polishing agent and mixing these, it is possible to concentrate the abrasive particle in the dispersion liquid to a concentration twice to 100 times that of the abrasive particle at the time of using the polishing agent and dilute the abrasive particle with the additive liquid for the polishing agent to a predetermined concentration.

### [Polishing Pad]

The polishing pad in the polishing method of the present disclosure has a polishing layer containing a polyurethane resin, the polyurethane resin includes a constitution unit derived from methylene diphenyl diisocyanate (MDI), and the content of the methylene diphenyl diisocyanate is 30 mass% or more based on the total mass of the polishing layer. The polishing pad contains 30 mass% or more of MDI in the polishing layer and is thereby capable of polishing particularly the surface to be polished including the insulating film at a higher rate.

MDI is present in the polishing layer as a part of the polyurethane resin, but the content ratio (mass%) is calculated as an MDI equivalent value.

A mechanism of an excellent polishing rate being obtained due to the fact that the polishing layer has 30 mass% or more of MDI is not clear, but is considered to arise from the fact that MDI contained in the polishing layer improves the moisture and heat resistance. Normally, the polyurethane resin becomes soft due to the contact with water for a long period of time, frictional heat that is generated during polishing, or the like. In contrast, when the polyurethane resin contains a certain amount or more of MDI, it is assumed that the moisture and heat resistance improves due to the structure, consequently, the polishing layer becoming excessively soft is suppressed, and an excellent polishing rate can be obtained. Furthermore, since the polishing layer becoming excessively soft can be suppressed, it is possible to select a relatively soft polishing layer having a shore A hardness of 90 degrees or less as the polishing layer, and consequently, the generation of polishing scratches can also be suppressed while an excellent polishing rate is maintained.

The layer configuration of the polishing pad is not particularly limited as long as the polishing layer is capable of coming into contact with the surface to be polished. The polishing pad may be a single film consisting of the polishing layer or may be a stacked body having the polishing layer on a substrate.

The polishing layer has at least a polyurethane resin and may further contain other components to an extent that the effect of the present invention is exhibited. Hereinafter, each component that can be contained in the polishing layer will be described.

### <Polyurethane Resin>

The polyurethane resin is a resin having two or more urethane bonds. As the polyurethane resin, not only polymers of a polyisocyanate and a polyol or a polyamine and polymers of a urethane prepolymer and a polyol or a polyamine but also resins obtained by polymerizing a conjugated diene, a dienophile, and a compound having a urethane bond or an isocyanate group by the Diels-Alder reaction are known, but polymers of a polyisocyanate and a polyol or polymers of a urethane prepolymer and a polyol are preferable from the viewpoint of chemical stability or the like, and resins having no cyclohexene rings are preferable from the viewpoint of heat resistance.

### (Polyisocyanate)

A polyisocyanate is a compound having two or more isocyanate groups. For the polyurethane resin of the present disclosure, at least methylene diphenyl diisocyanate (MDI) is used as the polyisocyanate, and a different polyisocyanate may also be used to an extent that the above-described content ratio is satisfied.

Examples of MDI include 2,2'-methylenediphenyl diisocyanate, 2,4'-methylenediphenyl diisocyanate, 4,4'-methylenediphenyl diisocyanate (monomeric MDI), polymeric MDI (a mixture of monomeric MDI and polymethylene polyphenyl polyisocyanate), or modified products thereof (for example, carbodiimide modified products, urethane modified products (adducts), allophanate modified products, urea modified products, biuret modified products, isocyanurate modified products, oxazolidone modified products), and the like. Among these, 4,4'-methylenediphenyl diisocyanate or carbodiimide modified MDI is preferable.

As the different polyisocyanate, diisocyanate or triisocyanate is preferable, and diisocyanate is more preferable.

Specific examples of the diisocyanate include benzene diisocyanates (phenylene diisocyanates) such as benzene-1,3-diisocyanate, benzene-1,4-diisocyanate, and m-phenylenebis(1-methylethane-1,1-diyl)diisocyanate (TMXDI); toluene diisocyanates (tolylene diisocyanates; TDIs) such as toluene-2,4-diisocyanate, toluene-2,5-diisocyanate, toluene-2,6-diisocyanate, and toluene-3,5-diisocyanate; xylene diisocyanates such as 1,2-xylene-3,5-diisocyanate, 1,2-xylene-3,6-diisocyanate, 1,2-xylene-4,6-diisocyanate, 1,3-xylene-2,4-diisocyanate, 1,3-xylene-2,5-diisocyanate, 1,3-xylene-2,6-diisocyanate, 1,3-xylene-4,6-diisocyanate, 1,4-xylene-2,5-diisocyanate, and 1,4-xylene-2,6-diisocyanate; naphthalene-1,5-diisocyanate, 4,4'-methylene-bis(cyclohexyl isocyanate) (hydrogenated MDI), 3,3'-dimethoxy-4,4'-biphenyl diisocyanate, 3,3'-dimethyldiphenylmethane-4,4'-diisocyanate, xylylene-1,4-diisocyanate, 4,4'-diphenylpropane diisocyanate, trimethylene diisocyanate, 1,5-pentamethylene diisocyanate, 1,6-hexamethylene diisocyanate, trimethylhexamethylene diisocyanate (TMDI), propylene-1,2-diisocyanate, butylene-1,2-diisocyanate, cyclohexylene-1,2-diisocyanate, cyclohexylene-1,4-diisocyanate, p-phenylene diisothiocyanate, xylylene-1,4-diisothiocyanate, m-xylylene diisocyanate (XDI), ethylidine diisothiocyanate, 1,4-cyclohexane diisocyanate (CHDI), 1,4-bis(isocyanatomethyl)cyclohexane, 1,2-bis(isocyanatomethyl)cyclohexane (hydrogenated XDI), isophorone diisocyanate (IPDI), norbornane diisocyanate (NBDI), and the like.

Specific examples of the triisocyanate include benzene-1,2,4-triisocyanate, benzene-1,2,5-triisocyanate, benzene-1,3,5-triisocyanate, toluene-2,3,5-triisocyanate, toluene-2,3,6-triisocyanate, toluene-2,4,5-triisocyanate, toluene-2,4,6-triisocyanate, toluene-3,4,6-triisocyanate, toluene-3,5,6-triisocyanate, 1,2-xylene-3,4,6-triisocyanate, 1,2-xylene-3,5,6-triisocyanate, 1,3-xylene-2,4,5-triisocyanate, 1,3-xylene-2,4,6-triisocyanate, 1,3-xylene-3,4,5-triisocyanate, 1,4-xylene-2,3,5-triisocyanate, 1,4-xylene-2,3,6-triisocyanate, and the like.

### (Polyol)

A polyol is a compound having two or more hydroxy groups. As the polyol, one type of the well-known polyols can be used singly or two or more types thereof can be used in combination. As the polyol, a diol, a triol, or a tetraol is preferable, and a diol is more preferable.

Specific examples of the diol include ethylene glycol, propylene glycol, diethylene glycol, dipropylene glycol, 1,2-butanediol, 1,3-butanediol, 1,4-butanediol, 1,2-pentanediol, 1,2-hexanediol, 1,5-pentanediol, 1,6-hexanediol, 2-methyl-2,4-pentanediol, 3-methyl-1,3-butanediol, 3-methyl-1,5-pentanediol, 2-butyl-2-ethyl-1,3-propanediol, 1,2-octanediol, 3,6-dithia-1,8-octanediol, 1,8-octanediol, 1,9-nonanediol, 1,2-decanediol, 1,10-decanediol, 1,12-dodecanediol, 1,4-bishydroxyethoxybenzene, 1,4-benzenedimethanol, EO (ethylene oxide) adducts of bisphenol A, PO (propylene oxide) adducts of bisphenol A, and the like.

Specific examples of the triol include glycerin, trimethylolethane, trimethylolpropane, 1,2,6-hexanetriol, and the like.

Specific examples of the tetraol include pentaerythritol, diglycerin, and the like.

In addition, a prepolymer-type polyol (a precursor of a polyurethane) may be used. Specific examples thereof include polyester polyols that are obtained by a reaction between the above-described low-molecular-weight polyol and a polybasic acid (for example, succinic acid, phthalic acid, hexahydrophthalic anhydride, terephthalic acid, adipic acid, azelaic acid, tetrahydrophthalic anhydride, or the like); polycaprolactone polyols that are obtained by a reaction between the above-described low-molecular-weight polyol and ε-caprolactone; polycarbonate polyols that are obtained by a reaction between the above-described low-molecular-weight polyol and diphenyl carbonate (for example, compounds that are obtained by reacting phosgene and an alkylene glycol such as 1,6-hexanediol, 3-methyl-1,5-pentanediol, 1,10-decanediol, or 1,5-pentanediol); polyether polyols to which the above-described low-molecular-weight polyol has been linked, and the like. Examples of the polyether polyols include polyethylene glycol, polypropylene glycol, polypropylene glycol having EO (ethylene oxide) added to an end, polytetramethylene glycol, ethylene oxide-modified bisphenol A, and the like. For all of the prepolymer-type polyols, the low-molecular-weight polyol is preferably a diol. In addition, from the viewpoint of the polishing rate of the insulating film, the prepolymer-type polyol is preferably, among them, polyester polyols (for example, condensates of a dicarboxylic acid such as adipic acid, azelaic acid, glutaric acid, phthalic acid, or isophthalic acid and a diol such as 1,6-hexanediol, neopentyl glycol, 1,3-propanediol, 1,3-butanediol, 1,4-butanediol, ethylene glycol, propylene glycol, cyclohexanedimethanol, trimethylolpropane, glycerin, or tris-hydroxyethyl isocyanurate) or polyether polyols (for example, polybutylene oxide glycol).

In addition, as another prepolymer-type polyol, polyols obtained by modifying ends or side chains of a variety of polymers (oligomers) with a hydroxy group may be used. Examples of such polyols include polybutadiene polyols (PBPs), castor oil polyols, silicone-based polyols, fluorine-based polyols, polymer polyols (polyols obtained by copolymerizing acrylonitrile, styrene, or the like in polyether polyol and dispersing fine polymer particles), polyrotaxane having a hydroxyl group, and the like.

The number average molecular weight of the prepolymer-type polyol is preferably 100 to 4000, more preferably 200 to 2000, and still more preferably 500 to 1000.

The number average molecular weight is a polystyrene equivalent value that is measured by GPC (gel permeation chromatography).

### (Urethane Prepolymer)

The urethane prepolymer is a polymer compound that is obtained by reacting a polyol and an excess polyisocyanate and has an isocyanate group at a molecular end group. The polyol and the polyisocyanate that configure the urethane prepolymer may be selected as appropriate from what has been described above.

A method for synthesizing the polyurethane resin is not particularly limited, and a well-known method can be used. In addition, a commercially available product having a desired structure may be used.

The content of MDI in the polyurethane resin needs to be 30 mass% or more and is preferably 35 mass% or more and more preferably 40 mass% or more based on the total mass of the polyurethane resin. The upper limit of the content of MDI in the polyurethane resin is not particularly limited, but is normally 60 mass% or less and preferably 55 mass% or less.

A partial structure in polyurethane and the content of MDI can be determined by NMR, IR, and mass analysis.

### <Other Components>

The polishing layer may further have other components to an extent that the effect of the present invention is exhibited. Examples of the other components include a foaming aid, fine particles such as carbon black or hollow particles, resins other than the polyurethane resin, a surfactant, and the like.

The foaming aid and the fine particles such as carbon black or hollow particles can be used for the purpose of, for example, the foaming of the polyurethane resin, the stabilization of the foam shape, or the like. The hollow particle is a particle having an outer shell and a void therein. Examples of the material of the outer shell include polyvinyl alcohols, polyvinylpyrrolidones, poly(meth)acrylic acids, poly(meth)acrylamide, polyethylene glycol, polyhydroxyether acrylate, maleic acid copolymers, polyethylene oxide, polyurethane, poly(meth)acrylonitrile, polyvinylidene chloride, polyvinyl chloride, organic silicone-based resins, and the like.

The shape of the fine particle is not particularly limited, and examples thereof include spherical shapes, substantially spherical shapes, and the like. In addition, the average particle diameter of the fine particles is, for example, 5 µm to 200 µm, preferably 5 µm to 80 µm, and more preferably 10 µm to 50 µm.

In the case of using the fine particles, the content thereof is preferably 1 mass% to 25 mass% and more preferably 2 mass% to 20 mass% based on the total mass of the polishing layer.

The rate of MDI in the polishing layer needs to be 30 mass% or more based on the total mass of the polishing layer. Particularly, the rate is preferably 35 mass% or more and more preferably 40 mass% or more from the viewpoint of the polishing rate. Incidentally, the upper limit of the content of MDI in the polishing layer is not particularly limited, but is normally 60 mass% or less and preferably 55 mass% or less.

### <Physical Properties and the Like of Polishing Layer>

In the polishing method of the present disclosure, the polishing layer is preferably a suede type. In the polishing method of the present disclosure, since the content of MDI in the polishing layer is 30 mass% or more, improvement in the polishing rate of particularly the surface to be polished including the insulating film and suppression of polishing scratches can be both achieved by combining the relatively soft suede-type polishing layer and the abrasive particle.

For example, in the case of a hard-type polishing layer having a shore A hardness of more than 90 degrees, there is a concern that polishing scratches may be generated at the time of increasing the polishing pressure during polishing.

The lower limit value of the shore A hardness of the polishing layer is preferably 30 degrees, more preferably 40 degrees, still more preferably 50 degrees, particularly preferably 60 degrees, and extremely preferably 65 degrees from the viewpoint of suppressing excess deformation and improving planarization performance. On the other hand, the upper limit value of the shore A hardness is preferably 90 degrees, more preferably 85 degrees, still more preferably 80 degrees, and particularly preferably 75 degrees from the viewpoint of suppressing polishing scratches by providing appropriate elasticity. The shore A hardness is a value measured from the polishing layer obtained by being peeled off from the polishing pad according to JIS K 7311.

The lower limit value of the water absorption coefficient of the polishing layer is preferably 5%, more preferably 10%, still more preferably 15%, particularly preferably 20%, extremely preferably 25%, and most preferably 30%. On the other hand, the upper limit value of the water absorption coefficient of the polishing layer is preferably 80%, more preferably 70%, still more preferably 65%, and extremely preferably 60%. When the water absorption coefficient of the polishing layer is within a range of 5% to 80%, the polishing agent is appropriately held in the polishing layer, the number of times of contact between the polishing agent and the surface to be polished increases, and the polishing efficiency per unit weight of the polishing agent thus improves.

The water absorption coefficient of the polishing layer is a value that is obtained as described below. A polishing layer of a test subject is made into a 5 cm × 5 cm test piece. In a case where the polishing layer is a polishing pad attached to a substrate, the polishing layer is used after being peeled off from the substrate. The weight (W_{d} [g]) of the test piece is measured in a sufficiently dry state. Next, the test piece is immersed in deionized water (DIW) warmed to 50°C for 16 hours.

The test piece is taken out from DIW, water droplets on the surface are all wiped off with dry BEMCOT, and the weight (W_{w} [g]) is measured within one minute. The water absorption coefficient is obtained from each measurement value and the following equation (1). Water absorption coefficient [%] = (Ww [g] - Wd [g])/Wd [g] × 100 · · · (1)

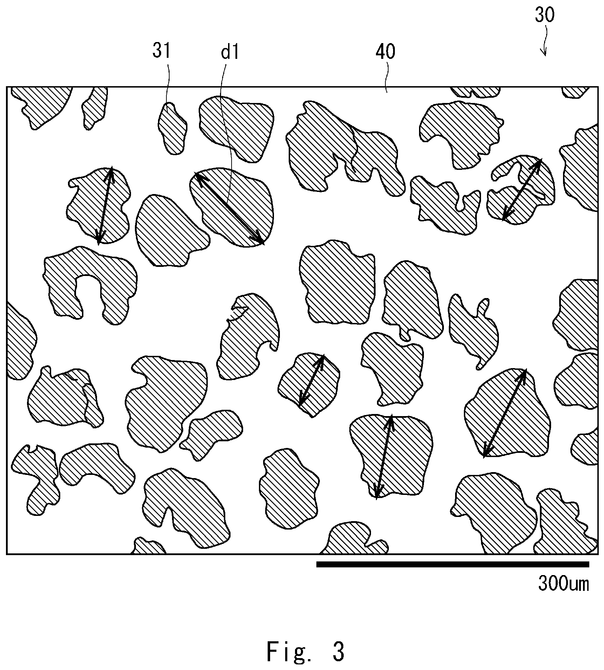

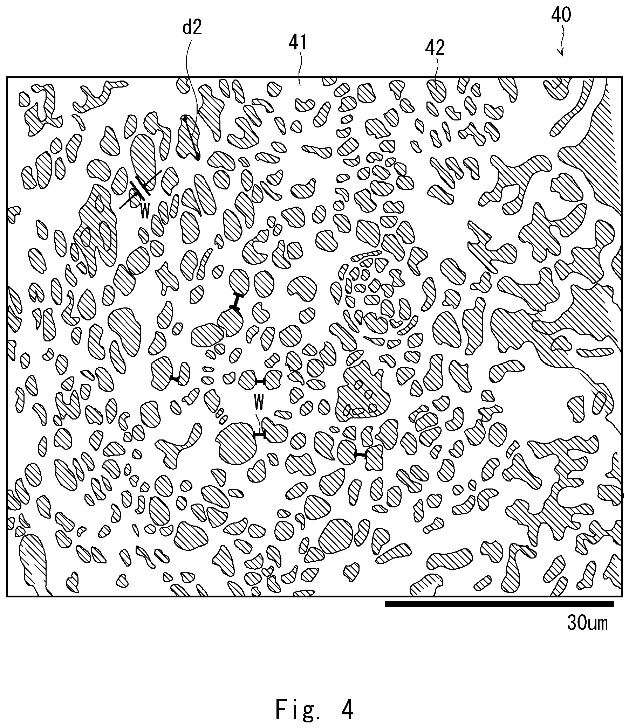

Next, a preferable shape of the polishing layer will be described. Fig. 3 is a schematic view of a cross section of a polishing layer 30, and Fig. 4 is a schematic view showing a surface of a polyurethane resin 40 in Fig. 3. Fig. 3 is an enlarged view at a magnification of approximately 250 times, and Fig. 4 is an enlarged view at a magnification of approximately 2000 times.

The polishing layer 30 shown in Fig. 3 is a porous layer having a plurality of pores 31 in the polyurethane resin 40. Furthermore, the polyurethane resin 40 preferably has a three-dimensional network-shaped structure as shown in Fig. 4 at the time of observing the surface of the polyurethane resin 40 in the polishing layer. In the polyurethane resin (part) 40 shown in Fig. 4, the three-dimensional network-shaped structure includes a network-shaped polyurethane resin 41 and fine pores 42 that are present as voids of the network. The use of the polishing layer having such a structure makes the water absorption coefficient appropriate and makes it possible to suppress the generation of polishing scratches while maintaining an excellent polishing rate.

The pores 31 represent pores that are observed in sizes of approximately 1% to 10% of a 600 µm × 600 µm visual field at the time of observation with a scanning electron microscope (SEM) at a magnification rate of 250 times in the visual field. In addition, the fine pores 42 represent fine pores that are observed in sizes of approximately 0.1% to 5% of a 100 µm × 100 µm visual field at the time of observation with a scanning electron microscope (SEM) at a magnification rate of 2000 times in the visual field.

The lower limit value of the average pore diameter (diameter) of the pores 31 is preferably 20 µm, more preferably 25 µm, still more preferably 30 µm, far still more preferably 35 µm, particularly preferably 40 µm, extremely preferably 45 µm, and most preferably 50 µm. On the other hand, the upper limit value thereof is preferably 150 µm, more preferably 130 µm, still more preferably 110 µm, particularly preferably 90 µm, and extremely preferably 70 µm. The pore diameters of the pores 31 represent the major axes (d1) of pores that are observed at a magnification rate of 250 times with a scanning electron microscope (SEM), and the average pore diameter is the average value of the pore diameters of 30 or more pores 31 that are observed in the visual field.

The average pore diameter (diameter) of the fine pores 42 is smaller than at least the average pore diameter of the pores 31, and the lower limit value thereof is preferably 0.1 µm, more preferably 0.5 µm, still more preferably 1 µm, far still more preferably 1.5 µm, and particularly preferably 2.5 µm. The pore diameters of the fine pores 42 represent the major axes of fine pores that are observed at a magnification rate of 2000 times with a scanning electron microscope (SEM), and the average pore diameter is the average value of the pore diameters of 30 or more fine pores 42 that are observed in the visual field.

In addition, the average thickness of the network-shaped polyurethane resin 41 is preferably 0.1 µm to 5.0 µm, more preferably 0.2 to 3.0 µm, and still more preferably 0.3 to 1.8 µm. The thickness of the polyurethane resin 41 is the width of the polyurethane resin 41 that is observed at a magnification rate of 2000 times with a scanning electron microscope (SEM) and may be obtained from the distance between two fine pores 42. The average thickness of the polyurethane resin 41 is the average value of the thicknesses of 30 or more polyurethane resin 41 that are observed in the visual field.

Furthermore, the lower limit value of the ratio (D₁/D₂) of the average pore diameter (D₁ [µm]) of the pores 31 to the average pore diameter (D₂ [µm]) of the fine pores 42 is 5.0, preferably 6.5, and more preferably 8.0. On the other hand, the upper limit value of D₁/D₂ is 200, preferably 150, more preferably 100, still more preferably 50, far still more preferably 40, particularly preferably 30, and most preferably 20. When the value of D₁/D₂ is within the above-described range, the water absorption coefficient becomes favorable, and it is also possible to suppress the generation of polishing scratches while maintaining an excellent polishing rate.

In the case of the hard-type polishing layer, even when being present, the fine pores 42 are too small to be observed with a scanning electron microscope (SEM) at a magnification rate of 2000 times, D₂ becomes an extremely small value, and it is thus assumed that D₁/D₂ becomes a value exceeding at least 100.

The thickness of the polishing layer is not particularly limited, can be set to, for example, approximately 0.3 mm to 2.0 mm, and is preferably 0.5 mm to 1.5 mm.

### <Method for Producing Polishing Layer (Polishing Pad)>

The polishing layer is preferably formed by a wet-type film forming method from the viewpoint of forming the suede-type polishing layer. Hereinafter, a specific example will be described.

First, a solution containing a polyurethane resin is prepared. The solution contains the polyurethane resin, a solvent, and other components that are used if necessary. As the solvent, a solvent that is capable of dissolving the polyurethane resin and is water-miscible can be used. Specific examples of the solvent include N,N-dimethylformamide (DMF), N,N-dimethylacetamide (DMAc), tetrahydrofuran (THF), dimethylsulfoxide (DMSO), N-methylpyrrolidone (NMP), acetone, and the like.

Next, the solution is applied onto a substrate for film formation to form a coated film. A method for applying the solution may be selected as appropriate from well-known methods by which the solution can be uniformly applied. In addition, the substrate for film formation is not particularly limited, flexible films, such as polyethylene terephthalate films, polyester films, and polyolefin films, may be used, and peelable substrates may also be used.

Next, the substrate onto which the solution has been applied is immersed in a coagulation liquid containing water as a main component. As the coagulation liquid, water, mixed solvent of water and a polar solvent, such as DMF, and the like can be used. As the polar solvent, the water-miscible organic solvent used to dissolve the polyurethane resin can be used. The concentration of the polar solvent in the mixed solvent is preferably 0.5 mass% to 30 mass%. The temperature or immersion time of the coagulation liquid is not particularly limited, and the coagulation liquid may be immersed, for example, at 5°C to 80°C for five to 60 minutes. This makes a polishing layer containing the polyurethane resin formed.

The obtained polishing layer is or is not peeled off from the substrate, and cleaning and drying treatments are performed thereon.

The cleaning treatment removes the organic solvent that remains in the polyurethane resin. Examples of a cleaning liquid that is used for the cleaning include water.

After the cleaning, a drying treatment is performed on the polyurethane resin. The drying treatment may be performed by a method that has been conventionally performed, and the polyurethane resin may be dried, for example, in a dryer at 80°C to 150°C for approximately five to 60 minutes. A suede-type soft polishing layer having a predetermined structure can be obtained by the above-described step.

To the obtained polishing layer, a different layer, such as a substrate, may be further laminated. The substrate is preferably a substrate having a higher shore A hardness than the polishing layer.

Furthermore, a grinding treatment, grooving, or embossing may be performed on the surface of the polishing layer if necessary.

### [Surface to be Polished]

In the present polishing method, the surface to be polished includes an insulating film. Examples of the material of the insulating film include silicon oxide, silicon nitride, polysilicon, and the like, and two or more types of insulating films may be disposed on one surface to be polished. According to the present polishing method, in a case where the surface to be polished contains silicon oxide even in the insulating film, the polishing rate or the selection ratio is particularly excellent.

Examples of the surface to be polished on which polishing is to be performed include surfaces including a silicon dioxide surface of a semiconductor substrate, blanket wafers including a silicon nitride film and a silicon oxide film stacked on a surface of a semiconductor substrate, patterned wafers in which these film types have been disposed in a pattern, and the like. Preferable examples of the semiconductor substrate include substrates for STI. The polishing agent of the present invention is also effective for polishing for the planarization of an interlayer insulating film between multilayer wirings in the production of a semiconductor device. The present polishing method improves the polishing rates of insulating films as one feature, but may also be applied to the polishing of surfaces to be polished having no insulating films.

Examples of a silicon oxide film in a substrate for STI include so-called PE-TEOS films formed by a plasma CVD method using tetraethoxysilane (TEOS) as a raw material. In addition, examples of a silicon oxide film can include so-called HDP films formed by a high-density plasma CVD method. In addition, HARP films or FCVD films formed by other CVD methods and SOD films formed by spin coating can also be used. Examples of a silicon nitride film include films formed by a low-pressure CVD method or a plasma CVD method using silane or dichlorosilane as a raw material and films formed by an ALD method.

### [Polishing Method]

In a polishing method of the present embodiment, the surface to be polished is brought into contact with the polishing layer of the polishing pad while the polishing agent is supplied thereto, to perform polishing through relative motion thereof.

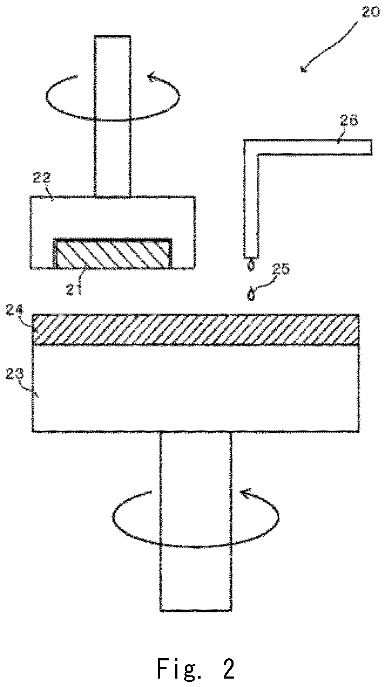

In the present polishing method, a well-known polishing device can be used. Fig. 2 is a schematic view showing one example of the polishing device. A polishing device 20 shown in the example of Fig. 2 includes a polishing head 22 configured to hold a semiconductor substrate 21 including a surface to be polished containing a resin, a polishing surface plate 23, a polishing pad 24 adhered onto a surface of the polishing surface plate 23, and a polishing agent supply pipe 26 configured to supply a polishing agent 25 to the polishing pad 24. In the configuration, while the polishing agent 25 is supplied from the polishing agent supply pipe 26, the surface to be polished of the semiconductor substrate 21 held in the polishing head 22 is brought into contact with the polishing pad 24, and polishing is performed by causing a relative rotary motion of the polishing head 22 and the polishing surface plate 23.

The polishing head 22 may perform not only a rotary motion but also a linear motion. In addition, the polishing surface plate 23 and the polishing pad 24 may be approximately as large as or smaller than the semiconductor substrate 21. In such a case, it is preferable that the entire surface to be polished of the semiconductor substrate 21 can be polished by relatively moving the polishing head 22 and the polishing surface plate 23. Furthermore, the polishing surface plate 23 and the polishing pad 24 may not perform a rotary motion and may be moved in one direction using, for example, a belt.

The polishing conditions of such a polishing device 20 are not particularly limited, and it is possible to increase the polishing pressure by applying a load to the polishing head 22 to press the polishing pad 24 and to improve the polishing rate. The polishing pressure is preferably approximately 0.5 to 50 kPa and more preferably approximately 3 to 40 kPa from the viewpoint of uniformity and planarization in the surface to be polished of the semiconductor substrate 21 at the polishing rate and the prevention of polishing scratches, such as scratches. The rotation speeds of the polishing surface plate 23 and the polishing head 22 are preferably approximately 50 to 500 rpm. In addition, the amount of the polishing agent 25 supplied is adjusted as appropriate depending on the composition of the polishing agent, each of the above-described polishing conditions, or the like.

If necessary, polishing may be performed while a pad conditioner is brought into contact with the surface of the polishing pad 24 and conditioning is performed on the surface of the polishing pad 24.

According to the present polishing method, it is possible to polish a surface to be polished including an insulating film at a high rate.

### · Method for Producing Semiconductor Component

A method for producing a semiconductor component according to the present invention includes singulating a semiconductor substrate having a surface to be polished that has been polished by the polishing method according to the present invention to provide a semiconductor component.

The method for producing a semiconductor component of the present disclosure has at least a singulating step of singulating a semiconductor substrate having a surface to be polished that has been polished by the polishing method. Examples of the singulating step include a step of obtaining a semiconductor component that is a semiconductor chip by dicing the semiconductor substrate (for example, a semiconductor wafer) by a well-known method such as blade dicing, laser dicing, or plasma dicing.

According to the present method for producing a semiconductor component may further have a bonding step of bonding a different member onto the surface to be polished of the semiconductor chip. The step makes it possible to obtain a semiconductor component that is a bonded body.

Examples of the different member include a second semiconductor chip, a redistributed layer, and the like. The second semiconductor chip may be a semiconductor chip obtained by the production method of the present disclosure or may be a semiconductor chip obtained by a different method. The bonding step may be, for example, a step of directly disposing a different member on the surface to be polished and directly bonding both by fusion bonding, surface activated bonding, or the like or may be a step of bonding the surface to be polished and a different member through an adhesive layer. Examples of the adhesive layer include metal layers such as solder and copper, glass layers, resin layers such as polyimide and epoxy, and the like.

The present disclosure is, furthermore, capable of providing an electronic device including at least one semiconductor component having a surface to be polished that has been polished by the polishing method of the present disclosure.

### Examples

Hereinafter, the present invention will be specifically described using Examples and Comparative Examples, but the present invention is not limited to these Examples. Examples 1 to 3 and Example 7 are the Examples, and Examples 4 to 6 and Examples 8 and 9 are the Comparative Examples.

### <Measurement Methods>

### [pH]

The pHs were measured using a pH meter HM-30R manufactured by DKK-TOA Corporation at a temperature set to 25 ± 5°C.

### [Average Secondary Particle Diameter]

The average secondary particle diameters were measured using a laser scattering/diffraction-type particle size analyzer (manufactured by Horiba, Ltd., device name: LA-950).

### [Shape of Polishing Layer]

The pore diameters of pores and fine pores and the thicknesses of network-shaped polyurethane resins were measured from cross sections of polishing layers with a scanning electron microscope (SEM) at a magnification rate of 250 times or 2000 times. As the pore diameters and the thicknesses, average values of 30 or more values observed in a visual field were obtained.

### [Water Absorption Coefficient of Polishing Layer]

A substrate was peeled off from each polishing pad, which will be described below, to produce a single-film polishing layer, and a 5 cm × 5 cm test piece was produced. The weight (W_{d} [g]) was measured in a state where each test piece had been sufficiently dried. Next, the test piece was immersed in deionized water (DIW) warmed to 50°C for 16 hours, the test piece was then taken out from DIW, water droplets on the surface were all wiped off with dry BEMCOT, the weight (W_{w} [g]) was measured within one minute, and the water absorption coefficient was obtained from the equation (1).

### [Composition of Polishing Pad]

### <Microscopic FT-IR>

A part of the polishing layer was collected, rolled and made into a thin film with a micro roller, the thin film was attached to a crystal plate (BaF₂) to produce a specimen, and microscopic FT-IR measurement was performed.
Measurement device: Manufactured by JASCO Corporation, microscopic FT-IR, FT-IR-4100, IRT-3000.
Scanning range: 4000 cm⁻¹ to 650 cm⁻¹

### <NMR>

A part of the polishing layer was collected and dissolved in DMF-d₇, and NMR measurement was performed.
Measurement device: Manufactured by JEOL Ltd., JNM-ECX400
Magnet: 400 MHz
Observation nuclear: ¹³C
Heavy solvent: DMF-d₇
Specimen concentration: Approximately 5 w/v%
Measurement temperature: 80°C

### <CHN Elemental Analysis>

A part of the polishing layer was collected, and CHN elemental analysis was performed.
Device: MICRO CORDER JM10 manufactured by J-Science Lab Co., Ltd.
Specimen furnace: 950°C
Combustion furnace: 850°C
Reduction furnace: 550°C

### [Polishing Agents]

Individual components were mixed together so that the following compositions were obtained, whereby polishing agents were prepared. In all of the polishing agents, the contents of ceria based on the total mass of an abrasive particle was 95 mass% or more.

### <Polishing Agent A>

| | |
|---|---|
| · Ceria particles having average secondary particle diameter of 110 nm | 0.25 mass% |
| · Polyacrylic acid | 0.053 mass% |
| · Nitric acid | 0.024 mass% |
| · Water | Balance |

### <Polishing Agent B>

| | |
|---|---|
| · Ceria particles having average secondary particle diameter of 110 nm | 0.25 mass% |
| · Water | Balance |

### [Polishing Pads]

Polishing pads having the following features were used.

### <Polishing Pad A>

· Thickness: 0.9 mm
· Polishing layer: Suede type, polyurethane resin contained as main component
· Polyurethane resin: Constitution unit derived from MDI and constitution unit derived from polyester polyol included, polyester polyol including constitution unit derived from adipic acid
· MDI content: 36 mass% (based on total mass of polishing layer) <Polishing Pad B>
· Thickness: 1.48 mm
· Polishing layer: Suede type, polyurethane resin contained as main component
· Polyurethane resin: Constitution unit derived from MDI and constitution unit derived from polytetramethylene glycol included
· MDI content: 51 mass% (based on total mass of polishing layer) <Polishing Pad C>
· Thickness: 1.23 mm
· Polishing layer: Suede type, polyurethane resin contained as main component
· Polyurethane resin: Constitution unit derived from MDI and constitution unit derived from polyester polyol included, polyester polyol including constitution unit derived from adipic acid
· MDI content: 27 mass% (based on total mass of polishing layer) <Polishing Pad D>
· Manufactured by DuPont, Model No: IC1400
· Thickness: 2.73 mm
· Polishing layer: Hard-type, polyurethane resin contained as main component
· Polyurethane resin: Constitution unit derived from TDI, constitution unit derived from polyether polyol, and constitution unit derived from 4,4'-methylenebis(2-chloroaniline) (MOCA) included
· MDI content: 0 mass% (based on total mass of polishing layer) <Polishing Pad E>
· Manufactured by DuPont, Model No: IK4250H
· Thickness: 2.84 mm
· Polishing layer: Hard-type, polyurethane resin contained as main component
· Polyurethane resin: Constitution unit derived from TDI, constitution unit derived from polyether polyol, and constitution unit derived from 4,4'-methylenebis(2-chloroaniline) (MOCA) included
· MDI content: 0 mass% (based on total mass of polishing layer)

### [Polishing Rate Evaluation]

### (Examples 1 to 6)

The following articles were prepared as objects to be polished (articles to be polished).
· Silicon dioxide film-attached blanket substrate having a silicon dioxide film formed by a plasma CVD method using tetraethoxysilane as a raw material on an eight-inch silicon wafer
· Silicon nitride film-attached blanket substrate having a silicon nitride film formed by the CVD method on an eight-inch silicon wafer
· Polysilicon film-attached blanket substrate having a polysilicon film formed by the CVD method on an eight-inch silicon wafer

Subsequently, the polishing agent and the polishing pad were combined together as shown in Table 1, and the articles to be polished were polished using a fully automated CMP polishing device (manufactured by Applied Materials, Inc., device name: Mirra). For the conditioning of the polishing pads, a diamond pad conditioner (manufactured by 3M, trade name: A82) was used in Examples 1 to 4, and a diamond pad conditioner (manufactured by 3M, trade name: A165) was used in Examples 5 and 6. As the polishing conditions, the polishing pressure was set to 20.7 kPa, the rotation speed of the polishing surface plate was set to 127 rpm, and the rotation speed of the polishing head was set to 123 rpm. In addition, the supply rate of the polishing agent was set to 200 milliliters/minute.

The polishing rate was calculated from the polishing time of the article to be polished and a change in the thickness, which was measured using a film thickness meter UV-1280SE manufactured by KLA-Tencor. In addition, the selection ratio (ratio between the polishing rates) was calculated from individual polishing rates. The results are shown in Table 1.

### [Table 1]

**Table 1**

| | | Example 1 | Example 2 | Example 3 | Example 4 | Example 5 | Example 6 |
|---|---|---|---|---|---|---|---|
| Polishing pad | | A | A | B | C | D | E |
| | Shore A hardness of polishing layer (degrees) | 72 | 72 | 72 | 60 | 94 | 97 |
| | MDI content of polishing layer (mass%) | 36 | 36 | 51 | 27 | 0 | 0 |
| | Water absorption coefficient of polishing layer (%) | 35 | 35 | 57 | 46 | 2.5 | 3.4 |
| | Thickness of polishing layer (mm) | 0.6 | 0.6 | 1.2 | 1 | 1.3 | 2 |
| | Average pore diameter D₁ (µm) | 53 | 53 | 54 | 64 | 18 | 12 |
| | Resin thickness (µm) | 0.9 | 0.9 | 1.1 | 1.9 | Unmeasurable | Unmeasurable |
| | Average fine pore diameter D₂ (µm) | 3 | 3 | 5.1 | 10.6 | Unmeasurable | Unmeasurable |
| | D₁/D₂ | 17.7 | 17.7 | 10.6 | 6.0 | - | - |
| Polishing agent | | A | B | A | A | A | A |
| | pH | 5 | 9 | 5 | 5 | 5 | 5 |
| TEOS polishing rate (Å/min) | | 1200 | 1000 | 1600 | 300 | 900 | 1200 |
| SiN polishing rate (Å/min) | | 85 | 260 | 90 | 50 | 50 | 65 |
| Polysilicon polishing rate (Å/min) | | 75 | 210 | 35 | 10 | - | - |
| TEOS/SiN selection ratio | | 14.12 | 3.85 | 17.78 | 6 | 18 | 18.46 |
| TEOS/polysilicon selection ratio | | 16.00 | 4.76 | 45.71 | 30 | - | - |

"Unmeasurable" in Table 1 means too small to be observed in a SEM image at a magnification of 2000 times.

In polishing methods of Example 1 to Example 3 where the polishing pads having the polishing layers in which the content of MDI was 30 mass% or more were used, it was shown that the polishing rates of TEOS, SiN, and the polysilicon were all superior to those in Example 4 to Example 6. This makes the control of the selection ratio easy and makes it possible to control the selection ratio by adjusting the pH as shown from, for example, the comparison between Example 1 and Example 2.

### [Polishing Scratch Evaluation]

### (Examples 7 to 9)

As objects to be polished (articles to be polished), silicon dioxide film-attached blanket substrates having a silicon dioxide film formed by the plasma CVD method using tetraethoxysilane as a raw material on a 12-inch silicon wafer were prepared.

Subsequently, the polishing agent and the polishing pad were combined together as shown in Table 2, and the articles to be polished were polished using a fully automated CMP polishing device (manufactured by EBARA Corporation, device name: F-Rex300X). For the conditioning of the polishing pads, a diamond pad conditioner (manufactured by 3M, trade name: A82) was used in Example 7, and a diamond pad conditioner (manufactured by 3M, trade name: A165) was used in Examples 8 and 9. As the polishing conditions, the polishing pressure was set to 20.7 kPa, the rotation speed of the polishing surface plate was set to 100 rpm, and the rotation speed of the polishing head was set to 101 rpm. In addition, the supply rate of the polishing agent was set to 250 milliliters/minute.

Polishing scratches were obtained by cleaning the article to be polished that had been polished 1000Å and then counting the number of polishing scratches as large as 0.05 µm or more per article to be polished using an optical wafer defect inspector (manufactured by KLA-Tencor, device name: Surfscan SP5) and a wafer defect review device (manufactured by KLA-Tencor, device name: eDR7280).

As a result, the numbers of polishing scratches were three in Example 7, 40 in Example 8, and 63 in Example 9. That is, it was shown that according to the polishing method of the present invention, it is possible not only to maintain the polishing rate or selection ratio of an insulating film as high as that in the case of using a hard pad but also to significantly suppress the generation of polishing scratches as shown in Table 1.

### [Table 2]

**Table 2**

| | | Example 7 | Example 8 | Example 9 |
|---|---|---|---|---|
| Polishing pad | | B | D | E |
| Polishing agent | | A | A | A |
| | pH | 5 | 5 | 5 |
| Polishing scratches (scratches) | | 5 | 40 | 63 |

### Industrial Applicability

According to the present invention, it is possible to realize high-speed polishing in CMP of, for example, a surface to be polished including an insulating film. Therefore, the polishing method of the present invention is suitable for the polishing of an insulating film for STI in semiconductor device production.

This application claims priority based on Japanese Patent Application No. 2022-168156, filed October 20, 2022, and Japanese Patent Application No. 2023-036300, filed March 9, 2023, the contents of which are incorporated herein by reference.

### Reference Signs List

- 1: SILICON SUBSTRATE
- 2: SILICON NITRIDE FILM
- 3: TRENCH
- 4: SILICON OXIDE FILM
- 20: POLISHING DEVICE
- 21: SEMICONDUCTOR SUBSTRATE
- 22: POLISHING HEAD
- 23: POLISHING SURFACE PLATE
- 24: POLISHING PAD
- 25: POLISHING AGENT
- 26: POLISHING AGENT SUPPLY PIPE
- 30: POLISHING LAYER
- 31: PORE
- 40: POLYURETHANE RESIN
- 41: NETWORK-SHAPED POLYURETHANE RESIN
- 42: FINE PORE
- d1: DIAMETER OF PORE
- d2: DIAMETER OF FINE PORE
- W: THICKNESS OF NETWORK-SHAPED POLYURETHANE RESIN

## Claims

1. A polishing method comprising bringing a surface to be polished of a semiconductor substrate into contact with a polishing pad while supplying a polishing agent to perform polishing through relative motion thereof, wherein
the polishing agent contains an abrasive particle and water,
the polishing pad has a polishing layer containing a polyurethane resin,
the polishing layer has a shore A hardness of 90 degrees or less,
the polishing layer has a water absorption coefficient of 5% or more,
the polyurethane resin includes a constitution unit derived from methylene diphenyl diisocyanate (MDI),
a content of the methylene diphenyl diisocyanate is 30 mass% or more based on a total mass of the polishing layer, and
the surface to be polished includes an insulating film.

2. The polishing method according to claim 1, wherein the abrasive particle comprises at least one selected from the group consisting of a silica particle, an alumina particle, a zirconia particle, a cerium compound particle, a titania particle, a germania particle, and a core-shell particle containing the above-listed particle as the core particle.

3. The polishing method according to claim 1, wherein the abrasive particle comprises a ceria particle.

4. The polishing method according to claim 1, wherein a content of the abrasive particle is 0.01 mass% to 10.0 mass% based on a total mass of the polishing agent.

5. The polishing method according to claim 1, wherein the polishing agent further contains a dispersant.

6. The polishing method according to claim 5, wherein the dispersant comprises at least one selected from the group consisting of an anionic surfactant, a cationic surfactant, a nonionic surfactant, and an amphoteric surfactant.

7. The polishing method according to claim 5, wherein a content of the dispersant is 0.0001 mass% to 0.3 mass% based on a total mass of the polishing agent.

8. The polishing method according to claim 1, wherein the polishing layer is a suede type.

9. The polishing method according to claim 1, wherein the polishing layer is produced by a wet film forming method.

10. The polishing method according to claim 1, wherein
the polishing layer is a porous layer having a plurality of pores in a polyurethane resin part, and
the polyurethane resin part has a three-dimensional network-shaped structure comprising a network-shaped polyurethane resin and fine pores.

11. The polishing method according to claim 10, wherein D₁/D₂ is 5.0 to 200, where D₁ represents an average pore diameter of the plurality of pores in the polyurethane resin part, and D₂ represents an average pore diameter of the fine pores.

12. The polishing method according to claim 1, wherein the polyurethane resin includes a constitution unit derived from a polyether polyol or a polyester polyol.

13. The polishing method according to claim 1, wherein the insulating film contains at least one selected from the group consisting of silicon oxide, silicon nitride, and polysilicon.

14. A method for producing a semiconductor component, comprising singulating a semiconductor substrate having a surface to be polished that has been polished by the polishing method according to any one of claims 1 to 13 to provide a semiconductor component.
